# EUROPÄISCHE PATENTANMELDUNG

(11) **EP 3 933 879 A1**
(43) Veröffentlichungstag der Anmeldung: **05.01.2022**
(21) Anmeldenummer: 20193548.3
(22) Anmeldetag: 31.08.2020
(51) Int. Cl.: H01H 59/00, H01H 1/00, H01H 71/00

(54) **ELEKTRONIKMODUL**

(30) Priorität: 29.06.2020 DE 102020208054
(71) Anmelder: Siemens Aktiengesellschaft, 80333 München (DE)
(72) Erfinder: Raab, Oliver, 94496 Ortenburg (DE); Schwarz, Markus, 80796 München (DE); Kiefl, Stefan, 80992 München (DE)

(57) **Zusammenfassung**

Das Elektronikmodul weist mindestens einen MEMS-Schalter mit einem Substrat und mindestens ein Halbleiter-Bauteil auf, bei welchem das mindestens eine Halbleiter-Bauteil mit dem Substrat gebildet und mit dem MEMS-Schalter verschaltet ist.

## Beschreibung

Die Erfindung betrifft ein Elektronikmodul.

Es ist bekannt, in Elektronikmodulen mittels MEMS-Schaltern (MEMS (engl.) = *"Micro-Electro Mechanical Systems")* zu schalten. Solche MEMS-Schalter weisen mikromechanisch gefertigte bewegliche Schaltelemente auf, welche zweckmäßig elektrisch, insbesondere elektrostatisch, betätigbar sind.

Ein Beispiel eines solchen MEMS-Schalters ist in Druckschrift DE102017215236A1 beschrieben.

MEMS-Schalter müssen für viele Anwendungszwecke in eine größere Schaltung eingebunden werden, um eine hinreichende Funktionalität sicherzustellen. Allerdings werden MEMS-Schalter konstruktionsbedingt typischerweise auf eigenen Substraten, auch Wafer genannt, aufgebaut, welche die Schaltkontakte des MEMS-Schalters tragen. Die Einbindung der MEMS-Schalter in die Gesamtschaltung ist häufig kosten- und raumintensiv. Zusätzlich resultieren aus der elektrischen Anbindung der MEMS-Schalter an einen übrigen Teil der Schaltung regelmäßig parasitäre Induktivitäten, Kapazitäten und Leitungswiderstände, die einen effizienten Betrieb der MEMS-Schalter erschweren.

Vor diesem Hintergrund ist es daher Aufgabe der Erfindung, ein verbessertes Elektronikmodul zu schaffen, welches insbesondere kosten- und/oder raumsparender aufbaubar ist und vorzugsweise effizienter betreibbar ist.

Diese Aufgabe der Erfindung wird mit einem Elektronikmodul mit den in Anspruch 1 angegebenen Merkmalen gelöst. Bevorzugte Weiterbildungen sind in den zugehörigen Unteransprüchen, der nachfolgenden Beschreibung und der Zeichnung angegeben.

Das erfindungsgemäße Elektronikmodul weist mindestens einen MEMS-Schalter mit einem Substrat auf, wobei das Elektronikmodul mindestens ein Halbleiter-Bauteil aufweist, welches mit dem Substrat gebildet und mit dem mindestens einen MEMS-Schalter verschaltet ist.

Auf diese Weise kann das erfindungsgemäße Elektronikmodul kompakter und kostengünstiger aufgebaut werden, da der Wafer des mindestens einen MEMS-Schalters zugleich zur Bereitstellung des mindestens einen Halbleiter-Bauteils dient. Zugleich ist eine aufwendige Verschaltung des mindestens einen MEMS-Schalters mit dem zumindest einen Halbleiter-Bauteil nicht erforderlich, da Leitungsverbindungen zwischen dem mindestens einen MEMS-Schalter und dem mindestens einen Halbleiter-Bauteil einfach in an sich bekannter Weise mittels oberflächlicher Metallisierungen des Substrats realisierbar sind. Folglich ist eine Anbindung an externe Halbleiter-Bauteile nicht erforderlich, sodass parasitäre Induktivitäten, Kapazitäten und Leitungswiderstände einfach vermeidbar sind. Vorzugsweise ist bei dem erfindungsgemäßen Elektronikmodul der mindestens eine MEMS-Schalter mit dem mindestens einen Halbleiter-Bauteil mittels mindestens einer Metallisierung des Substrats gebildet.

Vorteilhaft können mit dem erfindungsgemäßen Elektronikmodul nicht allein einfache Schaltfunktionen mittels des MEMS-Schalters bereitgestellt werden, sondern zusätzliche Funktionen können mittels des mindestens einen Halbleiter-Bauteils leicht ermöglicht werden. Insbesondere können solche zusätzlichen Funktionen Schutzfunktionen, insbesondere vor transienten Überspannungen oder eine Freilauffunktion in Umrichter-Anwendungen sein.

Im Gegensatz dazu weisen bei bekannten Elektronikmodulen die MEMS-Schalter lediglich eine einfache Schaltfunktionalität auf, während zusätzliche Funktionen meist mittels externer Bauteile realisiert werden müssen.

Vorzugsweise ist bei dem erfindungsgemäßen Elektronikmodul das mindestens eine Halbleiter-Bauteil mittels Dotierung des Substrats gebildet.

Das erfindungsgemäße Elektronikmodul lässt sich in dieser Weiterbildung vorteilhaft einfach fertigen. So kann das mindestens eine Halbleiter-Bauelement vor der Fertigung des eigentlichen MEMS-Schalters an dem Substrat ausgebildet werden, indem in das Substrat die erforderlichen Dotierungszonen, d.h. insbesondere p-Zonen und n-Zonen, nachfolgend auch als p-dotierte Bereiche und n-dotierte Bereiche bezeichnet, in an sich bekannter Weise eindotiert werden. Das Substrat kann dazu als Siliziumwafer, insbesondere mit oder aus Bulk-Silizium oder als SOI-Wafer (SOI = *"Silicon-on-Insulator"),* realisiert sein. Der Wafer ist grundsätzlich undotiert und/oder p-dotiert und/oder n-dotiert zur Fertigung heranziehbar.

Dotierungszonen sind in an sich bekannter Weise mithilfe von zum Beispiel in der CMOS-Technologie üblichen Verfahren in das Substrat einbringbar, insbesondere mittels Oxidation und/oder mittels Photolithographie und/oder mittels Ionenimplantation und/oder mittels Diffusion. Mittels Dotierstoffkonzentration und/oder Dotierprofilen und/oder Dotierkonzentrationen lassen sich Typ und Parameter des mindestens einen Halbleiter-Bauteils leicht einstellen. Eine Kontaktierung des mindestens einen Halbleiter-Bauteils ist bevorzugt mittels einer Metallisierung, insbesondere einer Halbleitermetallisierung, des Wafers vorhanden und kann grundsätzlich nach dem Dotieren ausgebildet werden, insbesondere während der Fertigung des MEMS-Schalters.

Bevorzugt ist bei dem Elektronikmodul gemäß der Erfindung der Wafer aus oder mit einem oder mehreren Halbleitern, insbesondere mit Silizium, und/oder aus oder mit einem Silicon-on-Insulator-Substrat gebildet.

Zweckmäßig ist bei dem erfindungsgemäßen Elektronikmodul das mindestens eine Halbleiter-Bauteil eine Diode oder diodenähnliches Bauteil wie eine Schottky-Diode oder PIN-Diode oder es weist eine solche Diode auf.

Vorteilhaft können Dioden als Überspannungsschutz mit den MEMS-Schaltern verschaltet sein und zweckmäßig zwischen unterschiedlichen Terminals vorgesehen sein, um vor Spannungspulsen in unterschiedlichen Leitungen zu schützen, insbesondere auch in Wechselspannungsanwendungen.

Geeigneterweise ist bei dem Elektronikmodul gemäß der Erfindung das mindestens eine Halbleiter-Bauteil eine serielle Anordnung von Dioden oder es weist eine solche serielle Anordnung auf.

Vorteilhaft können serielle Anordnungen von Dioden, d.h. Serienschaltungen von Dioden miteinander, die Spannungsfestigkeit der Dioden erhöhen.

Alternativ oder zusätzlich und ebenfalls vorteilhaft ist bei dem erfindungsgemäßen Elektronikmodul das mindestens eine Halbleiter-Bauteil eine parallele Anordnung von Dioden oder das mindestens eine Halbleiter-Bauteil umfasst eine solche parallele Anordnung.

Vorteilhaft können parallele Anordnungen von Dioden, d.h. Parallelschaltungen von Dioden miteinander, die Stromtragfähigkeit der Dioden erhöhen.

Bei dem erfindungsgemäßen Elektronikmodul verbindet das mindestens eine Halbleiter-Bauteil zweckmäßig einen Source-Anschluss und einen Drain-Anschluss des MEMS-Schalters miteinander.

Besonders bevorzugt ist das Halbleiter-Bauteil eine Diode, die insbesondere parallel oder antiparallel zu Drain- und Source-Anschluss geschaltet ist. In dieser Weiterbildung der Erfindung kann das Halbleiter-Bauteil vorteilhaft als Überspannungsschutz, insbesondere in der Art einer Freilauf-Diode, dienen.

Alternativ oder zusätzlich und ebenfalls vorteilhaft verbindet bei dem erfindungsgemäßen Elektronikmodul das mindestens eine Halbleiter-Bauteil Gate-Anschlüsse des MEMS-Schalters miteinander.

Alternativ oder zusätzlich und ebenfalls vorteilhaft ist bei dem erfindungsgemäßen Elektronikmodul das mindestens eine Halbleiter-Bauteil Teil einer Zuleitung zu einem Source-Anschluss und/oder Drain-Anschluss und/oder Gate-Anschluss ist.

In dieser Weiterbildung der Erfindung ist das Halbleiter-Bauteil geeigneterweise zudem eine Diode, sodass mittels des erfindungsgemäßen Elektronikmoduls vorteilhaft ein Step-Up-Konverter oder ein anderer Konverter/Teil eines Konverters realisierbar ist.

Vorzugsweise ist bei dem erfindungsgemäßen Elektronikmodul das Halbleiter-Bauteil eine Diode und verbindet Gate-Anschluss und Source-Anschluss und/oder Gate-Anschluss und Drain-Anschluss des MEMS-Schalters. In dieser Weiterbildung ist vorteilhaft ein Überspannungsschutz mittels der Diode realisiert.

Vorzugsweise weist bei dem Elektronikmodul gemäß der Erfindung der MEMS-Schalter ein Biegeelement auf.

Bevorzugt ist bei dem erfindungsgemäßen Elektronikmodul das Biegeelement ein Biegebalken.

Nachfolgend wird die Erfindung anhand eines in der Zeichnung dargestellten Ausführungsbeispiels näher erläutert. Es zeigen:
- Fig. 1: ein erfindungsgemäßes Elektronikmodul mit einem MEMS-Schalter und einem Halbleiter-Bauteil schematisch in einer Draufsicht,
- Fig. 2: ein Ersatzschaltbild des Elektronikmoduls gem. Fig. 1 schematisch in einer Prinzipskizze,
- Fig. 3: ein weiteres Ausführungsbeispiel eines erfindungsgemäßen Elektronikmoduls mit einem MEMS-Schalter und einer Reihe von Halbleiter-Bauteilen auf einer Lastseite des MEMS-Schalters schematisch in einer Draufsicht,
- Fig. 4: ein Ersatzschaltbild des Elektronikmoduls gem. Fig. 3 schematisch in einer Prinzipskizze,
- Fig. 5: ein weiteres Ausführungsbeispiel eines erfindungsgemäßen Elektronikmoduls mit einem MEMS-Schalter und einem Halbleiter-Bauteil auf einer Steuerseite des MEMS-Schalters schematisch in einer Draufsicht,
- Fig. 6: ein Ersatzschaltbild des Elektronikmoduls gem. Fig. 5 schematisch in einer Prinzipskizze,
- Fig. 7: ein weiteres Ausführungsbeispiel eines erfindungsgemäßen Elektronikmoduls mit einem MEMS-Schalter und einem Halbleiter-Bauteil schematisch in einer Draufsicht sowie
- Fig. 8: ein Ersatzschaltbild des Elektronikmoduls gem. Fig. 7 schematisch in einer Prinzipskizze.

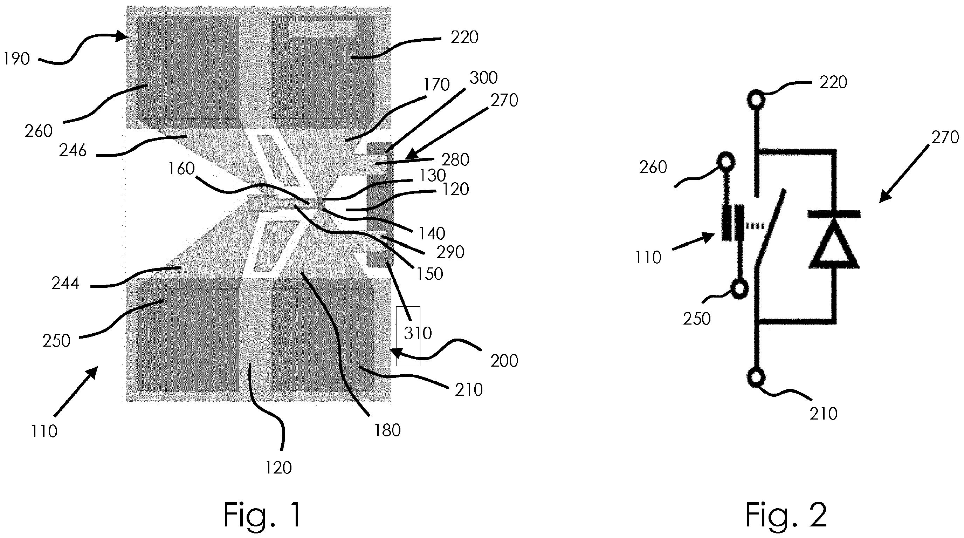

Der in Fig. 1 dargestellte MEMS-Schalter 110 ist in an sich bekannter Weise mit einem Silizium-Wafer, im dargestellten Ausführungsbeispiel einem Silicon-on-Insulator-Wafer 120 (SOI-Wafer), gebildet. In weiteren nicht eigens dargestellten Ausführungsbeispielen kann der MEMS-Schalter 110 stattdessen auch mit einem vollständig aus Silizium gebildeten Wafer gebildet sein.

Der MEMS-Schalter 110 weist zwei Schaltkontakte 130, 140 in Gestalt von Oberflächenmetallisierungen auf, welche in an sich bekannter Weise an dem SOI-Wafer 120 oberflächlich angeordnet sind. Die beiden Schaltkontakte 130, 140 sind voneinander beabstandet und können mittels eines beweglichen Schaltkontakts miteinander elektrisch leitend verbunden, d.h. zusammengeschaltet, werden. Der bewegliche Schaltkontakt ist an einem Biegeelement des MEMS-Schalters 110, im dargestellten Ausführungsbeispiel einem Biegebalken 150, angeordnet. Der bewegliche Schaltkontakt ist an einem freien Ende 160 des Biegebalkens 150 angeordnet, welches sich von einem fixen Ende des Biegebalkens 150, welches an den übrigen Teilen des SOI-Wafers 120 festliegt, in Richtung einer Längserstreckung des Biegebalkens 150 fortstreckt. Der bewegliche Schaltkontakt ist infolge einer Auslenkung des freien Endes des Biegebalkens 150 beweglich.

Der Biegebalken 150 ist grundsätzlich wie in Druckschrift DE102017215236A1 beschrieben aus dem SOI-Substrat subtraktiv gefertigt.

Die an dem SOI-Wafer 120 angeordneten Schaltkontakte 130, 140 sind jeweils an Zuleitungen 170, 180 elektrisch leitend angebunden, welche voneinander in Richtung senkrecht zur Längserstreckung des Biegebalkens 150 fortführen und jeweils in einem Anschlussbereich 190, 200 in Anschlüssen, einem Source-Anschluss 210 und einem Drain-Anschluss 220, enden. Die Zuleitungen 170, 180 weiten sich zwischen den Schaltkontakten 130, 140 und den Anschlüssen jeweils von mikroskopischen Abmessungen, d.h. von Abmessungen zwischen zehn und fünfzig Mikrometern, auf makroskopisch handhabbare Abmessungen auf, welche ein Vielfaches der genannten mikroskopischen Abmessungen betragen. Die Anschlüsse bilden einen Source-Anschluss 210 und einen Drain-Anschluss 220 des MEMS-Schalters 110.

Der MEMS-Schalter 110 wird elektrostatisch gesteuert, d.h. geschaltet. Der MEMS-Schalter 110 weist dazu einen Steuerkontakt an dem Biegebalken 150 des MEMS-Schalters 150 auf, welcher einem weiteren Steuerkontakt an einem übrigen Teil des SOI-Wafers 120 zugewandt ist. Bei gegenpoliger Spannungsbeaufschlagung der Steuerkontakte wird der Biegebalken 150 des MEMS-Schalters 110 zu den übrigen Teilen des SOI-Wafers 120 hingezogen und so in eine Schließstellung des MEMS-Schalters 110 gesteuert. Bei gleichpoliger Spannungsbeaufschlagung der Steuerkontakte 230, 240 wird der MEMS-Schalter 110 geöffnet.

Die Steuerkontakte 230, 240 sind mittels sich jeweils in makroskopisch handhabbare Abmessungen aufweitende Zuleitungen 244, 246 mit Anschlüssen elektrisch leitend verbunden, welche Gate-Anschlüsse 250, 260 des MEMS-Schalters 110 bilden. Die Gate-Anschlüsse 250, 260 sind ebenfalls in den Anschlussbereichen 190, 200 befindlich. Mittels dieser Anordnung lässt sich also mit dem MEMS-Schalter 110 durch eine Ansteuerung mittels der Gate-Anschlüsse 250, 260 ein Stromfluss zwischen dem Source-Anschluss 210 und dem Drain-Anschluss 220 steuern.

Der MEMS-Schalter 110 ist mit einem Halbleiter-Bauteil in Gestalt einer Diode 270 verschaltet. Dazu sind an den Zuleitungen 170, 180 Dioden-Anschlüsse 280, 290 ausgebildet, welche jeweils eine Oberflächenmetallisierung des SOI-Wafers 120 bilden und welche sich in Richtung der Längserstreckung des Biegebalkens 150 in Richtung von diesem fort strecken.

Die Diodenanschlüsse 280, 290 führen zu dotierten Bereichen 300, 310 des SOI-Wafers 120, welche die Diode 270 bilden. Dabei kontaktiert der Diodenanschluss 280 die Zuleitung 170 mit einem n-dotierten Bereich 300 des SOI-Wafers 120 elektrisch. Der Diodenanschluss 290 kontaktiert die Zuleitung 180 mit einem p-dotierten Bereich 310 des SOI-Wafers 120, welcher den n-dotierten Bereich 300 des SOI-Wafers umgibt, d.h. der n-dotierte Bereich 300 ist in flächigen Richtungen einer Oberfläche des SOI-Wafers 120 vom p-dotierten Bereich 310 vollumfänglich umgeben. Zudem grenzt der p-dotierte Bereich 310 in Tiefenrichtungen des SOI-Wafers 120 den n-dotierten Bereich 300 von übrigen Teilen des SOI-Wafers 310 vollständig ab, indem der p-dotierte Bereich 310 zwischen dem n-dotierten Bereich 300 und übrigen Teilen des SOI-Wafers 120 befindlich ist.

Folglich bildet sich zwischen den p-dotierten Bereich 310 und dem n-dotierten Bereich 300 ein p-n-Übergang aus, welcher ein Stromventil in Gestalt der Diode 270 bildet. Die Diode 270 verbindet in dem in Figur 1 dargestellten Ausführungsbeispiel Source-Anschluss 210 und Drain-Anschluss 220 miteinander.

Die auf demselben SOI-Wafer 120 ausgebildete Anordnung von MEMS-Schalter 110 und Diode 270 bildet ein erfindungsgemäßes Elektronikmodul aus und ist in Fig. 2 in einem Ersatzschaltbild dargestellt.

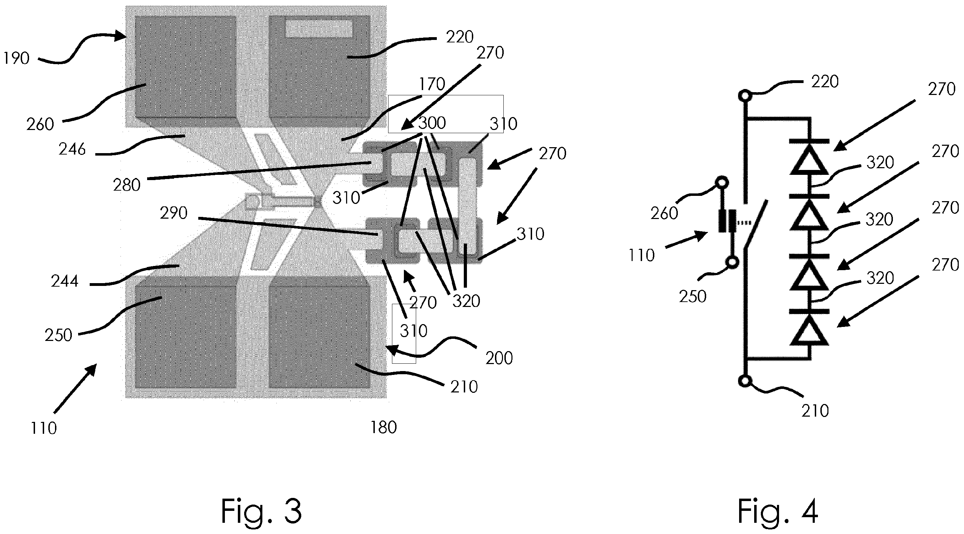

Ein zweites, in den Figuren 3 und 4 dargestelltes, Ausführungsbeispiel des erfindungsgemäßen Elektronikmoduls ist grundsätzlich gleichartig dem in den Figuren 1 und 2 dargestellten ersten Ausführungsbeispiel aufgebaut.

Eine Abweichung des zweiten Ausführungsbeispiels besteht wie in Fig. 3 dargestellt allerdings darin, dass anstelle einer einzigen Diode 270 vier in Serie geschaltete Dioden 270 vorhanden sind. Die Dioden 270 sind in einer in Richtung des Biegebalkens 150 geöffneten U-Form zwischen den Diodenanschlüssen 280, 290 angeordnet und an diese kontaktiert. Die Dioden 270 sind miteinander über Oberflächenmetallisierungen 320 elektrisch verbunden, welche in an sich bekannter Weise auf dem SOI-Wafer 120 oberflächlich aufgebracht sind. Die serielle Anordnung der vier Dioden 270 erhöht die Spannungsfestigkeit gegenüber einer einzelnen Diode 270.

Figur 4 zeigt ein Ersatzschaltbild für die in Fig. 3 abgebildete Anordnung.

In einem dritten Ausführungsbeispiel des erfindungsgemäßen Elektronikmoduls, welches grundsätzlich den zuvor beschriebenen Ausführungsbeispielen im Übrigen entspricht, verbindet die Diode 270 nicht Source-Anschluss 210 und Drain-Anschluss 220 miteinander, sondern die Gate-Anschlüsse 250, 260. Dazu sind die Diodenanschlüsse 280, 290 nicht aus den Zuleitungen 170, 180 ausgebildet, sondern die Diodenanschlüsse 280, 290 bilden Teile der Zuleitungen 244, 246 der Gateanschlüsse 250, 260 und strecken sich von dem Biegebalken 150 in Richtung der Längserstreckung des Biegebalkens 150 von diesem fort. Die Diode 270 ist im gezeigten Ausführungsbeispiel aufgebaut wie die Diode 270 im zuvor beschriebenen Ausführungsbeispiel.

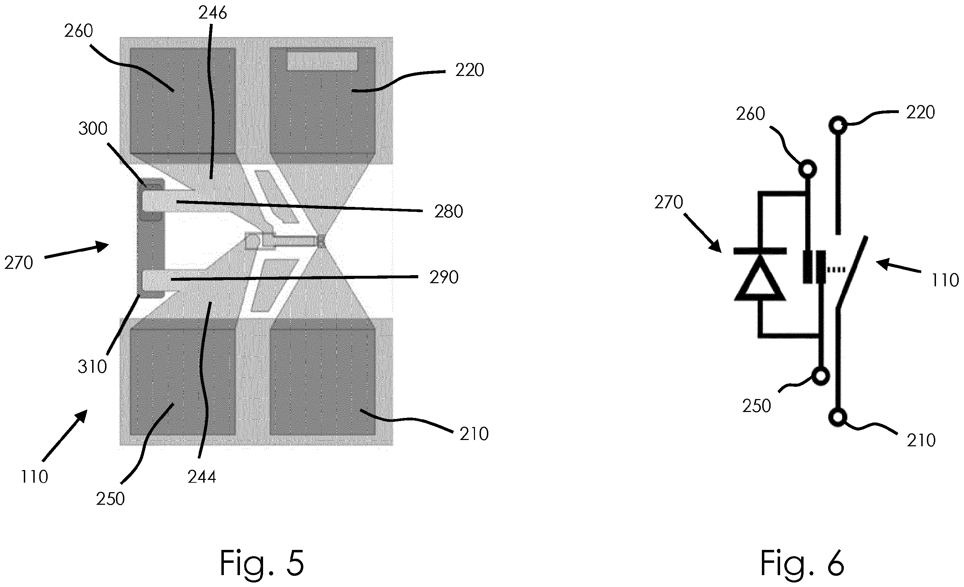

Ein Ersatzschaltbild für diese Konfiguration ist in Fig. 5 angegeben.

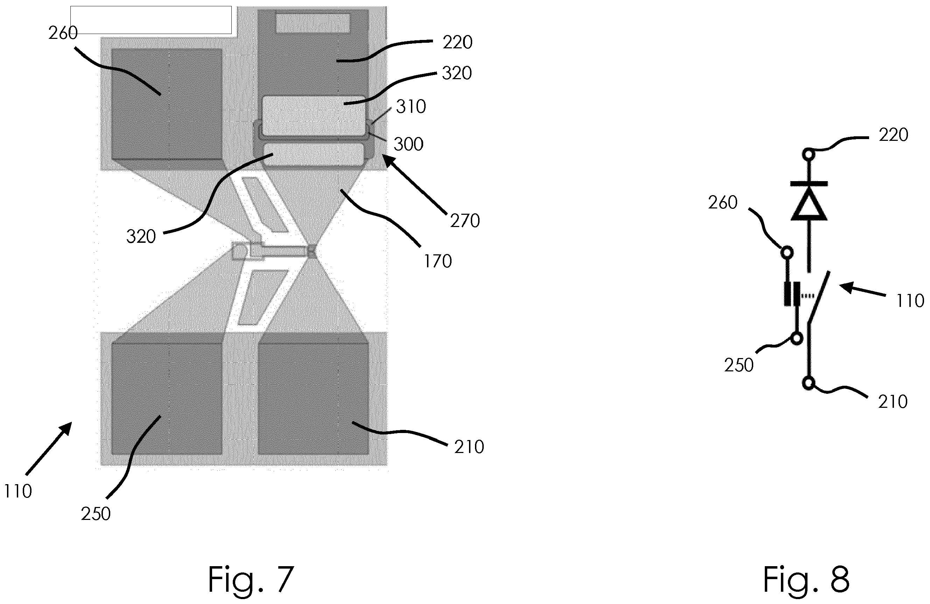

In einem vierten in Fig. 7 dargestellten Ausführungsbeispiel ist die Diode 270 im Gegensatz zu den oben beschriebenen Ausführungsbeispielen Teil der Zuleitung 170 des Drain-Anschlusses 220. Dazu ist die Diode 270, welche identisch zu den Dioden 270 der vorhergehend beschriebenen Ausführungsbeispiele aufgebaut ist, mittels Oberflächenmetallisierungen 320 an den Drain-Anschluss 220 und an die übrigen Teile der Zuleitung 170 angebunden.

Ein Ersatzschaltbild für diese Anordnung ist in Fig. 8 angegeben.

Grundsätzlich kann die Diode 270 in weiteren, nicht eigens dargestellten Ausführungsbeispielen als Überspannungsschutz einen Gate-Anschluss 250, 260 des MEMS-Schalters mit einem Source-Anschluss 210 des MEMS-Schalters 110 oder mit einem Drain-Anschluss 220 des MEMS-Schalters 110 verbinden.

## Patentansprüche

1. Elektronikmodul aufweisend mindestens einen MEMS-Schalter (110) mit einem Substrat (120) und aufweisend mindestens ein Halbleiter-Bauteil (270), bei welchem das mindestens eine Halbleiter-Bauteil (270) mit dem Substrat (120) gebildet und mit dem mindestens einen MEMS-Schalter (110) verschaltet ist.

2. Elektronikmodul nach dem vorhergehenden Anspruch, bei welchem das mindestens eine Halbleiter-Bauteil (270) mittels Dotierung des Substrats (120) gebildet ist.

3. Elektronikmodul nach einem der vorhergehenden Ansprüche, bei welchem das Substrat (120) aus oder mit einem oder mehreren Halbleitern, insbesondere mit Silizium, und/oder aus oder mit einem Silicon-on-Insulator-Wafer und/oder Silicon-on-Insulator-Substrat gebildet ist.

4. Elektronikmodul nach einem der vorhergehenden Ansprüche, bei welchem das mindestens eine Halbleiter-Bauteil (270) eine Diode, insbesondere eine pn-Diode und/oder eine Schottky-Diode oder eine PIN-Diode, ist oder aufweist.

5. Elektronikmodul nach einem der vorhergehenden Ansprüche, bei welchem das mindestens eine Halbleiter-Bauteil (270) eine serielle und/oder parallele Anordnung von Dioden ist oder aufweist.

6. Elektronikmodul nach einem der vorhergehenden Ansprüche, bei welchem das mindestens eine Halbleiter-Bauteil (270) einen Source-Anschluss (210) und einen Drain-Anschluss (220) des mindestens einen MEMS-Schalters verbindet.

7. Elektronikmodul nach einem der vorhergehenden Ansprüche, bei welchem das mindestens eine Halbleiter-Bauteil Gate-Anschlüsse (250, 260) des mindestens einen MEMS-Schalters (110) miteinander verbindet.

8. Elektronikmodul nach einem der vorhergehenden Ansprüche, bei welchem das mindestens eine Halbleiter-Bauteil (270) Teil einer Zuleitung (170) zu einem Source-Anschluss (210) und/oder Drain-Anschluss (220) und/oder Gate-Anschluss (250, 260) des mindestens einen MEMS-Schalters ist.

9. Elektronikmodul nach einem der vorhergehenden Ansprüche, bei welchem der mindestens eine MEMS-Schalter (110) ein Biegeelement (150) aufweist.

10. Elektronikmodul nach einem der vorhergehenden Ansprüche, bei welchem das Biegeelement (150) ein Biegebalken ist.
